# EUROPEAN PATENT SPECIFICATION

(11) **EP 0 554 849 B1**
(45) Date of publication and mention of the grant of the patent: **10.05.2000**
(21) Application number: 93101639.8
(22) Date of filing: 03.02.1993
(51) Int. Cl.: G02B 6/42, H01L 31/0352, H01L 31/103

(54) **Semiconductor light detecting device**
Halbleiter-Lichtdetektorvorrichtung
Dispositif semi-conducteur détecteur de lumière

(30) Priority: 03.02.1992 JP 1760692; 03.02.1992 JP 1762092
(43) Date of publication of application: 11.08.1993
(73) Proprietor: SUMITOMO ELECTRIC INDUSTRIES, LIMITED, Osaka 541 (JP)
(72) Inventor: Kuhara, Yoshiki, c/o Osaka Works of, Konohana-ku, Osaka (JP); Koseki, Hideaki, c/o Osaka Works of, Konohana-ku, Osaka (JP); Michikoshi, Hisato, c/o Osaka Works of, Konohana-ku, Osaka (JP)
(74) Representative: Kahler, Kurt, Dipl.-Ing.

(56) References cited:
- EP-A- 0 279 492
- EP-A- 0 407 671
- EP-A- 0 428 159
- DE-A- 3 921 441
- DE-A- 4 022 076
- DE-C- 3 705 408
- PATENT ABSTRACTS OF JAPAN vol. 15, no. 111 (P-118) 18 March 1991 & JP-A-03 002 807 ( NEC )
- IEEE Proceedings Journal Optoelectronics, Vol.137, No.3, (1990), pages 171-173

## Description

This invention relates to a semiconductor light detecting device for use in receivers, etc. of optical communication systems.

In a semiconductor light detecting device for use in the optical communication using optical fibers, conventionally a photodiode chip as the light detecting means is mounted on a header and a lead wire is bonded to the photodiode, whereby the signal light emitted from the end surface of an optical fiber is taken out to be converted into an electric signal.

Another conventional semiconductor light detecting device (prior art) is called butterfly type. The device of this type has a housing of rectangular section. It is possible to dispose an IC (integrated circuit) on a header secured inside a housing to amplify to some extent a photocurrent (photoelectric current signal) generated in the p-n junction of the photodiode chip as the light detecting means and take out the amplified photocurrent.

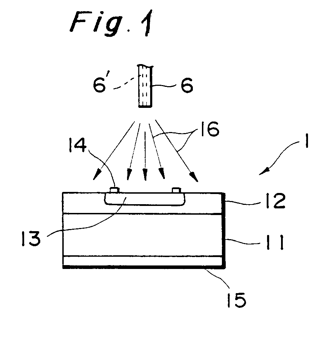

The photodiode chip 1 as the light detecting means comprises, as shown in Fig. 1, an epitaxial layer 12 grown on a semiconductor substrate 11, and a diffusion region 13 formed on a surface of the epitaxial layer 13 and having a polarity opposite to that of the epitaxial layer 13 by diffusing a metal element.

Since the interface between the epitaxial layer and the diffusion region 13 has a p-n junction, a generated photoelectric current is taken out as an electric signal through electrodes 14, 15.

But this conventional semiconductor light detecting device has the following problems.

In a case in which a single mode fiber or a multimode fiber is used as the optical fiber 6, for, e. g., light of 1.3 µm band, the core is about 10 µm in diameter for the single mode fiber, and about 50 µm in diameter for the multimode fiber. The light 16 emitted from the end surface of the optical fiber 6 disperses at an angle corresponding to a refractive index difference between the core and the clad of the optical fiber 6.

What is especially a problem is a case where a condensed beam (signal light emitted from the end surface of the optical fiber) is radiated onto parts other than the light detecting region of the photodiode (Reference numeral 16 represents a divergence of a beam radiated from the core 6' of the optical fiber 6).

A part of the signal light absorbed in the light detecting region 13 and its neighborhood (e. g., 3 - 5 µm) contributes to the generation of a photoelectric current effectively at high speed because of an electric field applied to the p-n junction, but because of the absence of. an electric field a part of the signal light absorbed outside the light detecting region and its neighborhood adversely generates a photoelectric current of very low response speed.

As a result of the latter case, in reproducing an analog signal light (photoelectric conversion), a resultant signal is a phase shift resultantly with a high distortion level. A problem is that a reproduced signal waveform has noises. In reproducing a digital signal light (photoelectric conversion), a reproduced signal waveform has a distortion (especially a rectangular pulse has a dragging trailing edge of µsec at the fall). A problem is that high-speed communication cannot be performed.

In the EP-A-0 428 159 a light-receiving device is disclosed comprising an absorption layer formed of a semiconductor material which is capable of generating electric charges in response to an incident light, a plurality of light-detecting regions formed in the absorption layer, each outputting an electric signal in response to an incident light signal, and a depletion region formed between the adjacent light-detecting regions for collecting electric charges generated in a portion of the absorption layer between the adjacent light-detecting regions.

In the DE-A-39 21 441 a device is disclosed consisting of a transistor socket with a photodiode thereon and means in which the optical fiber is adjusted.

Both the disclosures of the above cited documents are directed to solve a fabrication problem rather than a problem at the time of applying an optical fiber with an inclined light emitting surface.

Under these circumstances, to remove these problems the signal light emitted from the end surface of the optical fiber has been condensed to the light detecting region (p-n junction) of the photodiode chip through an expensive and high-quality optical lens system.

Although the semiconductor light detecting devices are essential to the optical communication, the semiconductor light detecting devices have the above described problems and in addition expensive parts, which hinders the progressive prevalence of the optical communication systems.

In EP-A-0279492, a radiation-sensitive semiconductor device is disclosed comprising a a high-ohmic semiconductor wafer having a thicker edge portion and a thinner central portion, in which a photo diode is located. An object of this invention is to solve the above-described problems, secure stable operations, and to simplify the fabrication and structure of the semiconductor light detecting device itself.

The semiconductor light detecting device of the invention as defined in claim 1 comprises a housing having an optical fiber inserted therein and being secured to a header having a photodiode chip mounted thereon integrally therewith, a light detecting surface of the photodiode chip being opposed to a signal light emitting end surface of the optical fiber, the photodiode chip comprising a p-n junction as the light detecting surface for outputting a photocurrent as a detected signal, and a region for capturing carriers generated in a peripheral area of the p-n junction, the light detecting surface of the photodiode chip being opposed to the signal light emitting end surface of the optical fiber.

In the semiconductor light detecting device according to a second aspect of the invention, the light detecting surface of the photodiode chip is opposed to the signal light emitting end surface of the optical fiber through an optical lens system.

The photodiode chip involved in the first and the second aspects of the invention comprises a p-n junction as the light detecting region formed by thermal diffusion of a metal element on an epitaxial layer grown on a substrate (the region having a polarity opposite to that of the epitaxial layer), the charge capturing region being formed in the peripheral area by the same method.

According to the invention, because the photodiode chip as the light detecting means is provided by a photodiode chip including a region for capturing unnecessary reactive carriers, no signal waveform distortions never take place even when signal light is radiated from the end surface of the optical fiber without an optical lens system disposed therebetween or with an inexpensive spherical lens being disposed therebetween.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the scope of the invention will become apparent to those skilled in the art from this detailed description.

Brief description of the drawings:
- Fig. 1: is a sectional view of a conventional photodiode chip installed in the conventional light detecting devices.
- Fig. 2: is a broken side view of the semiconductor light detecting device according to a first embodiment of this invention with a major part broken.
- Fig. 3: is a broken side view of the semiconductor light detecting device according to a second embodiment of the invention.
- Fig. 4: is a broken side view of the semiconductor device according to an alternative of the second embodiment of this invention.
- Fig. 5: is a sectional view of a photodiode chip installed in the semiconductor light detecting devices according to the first and the second embodiments of the invention.

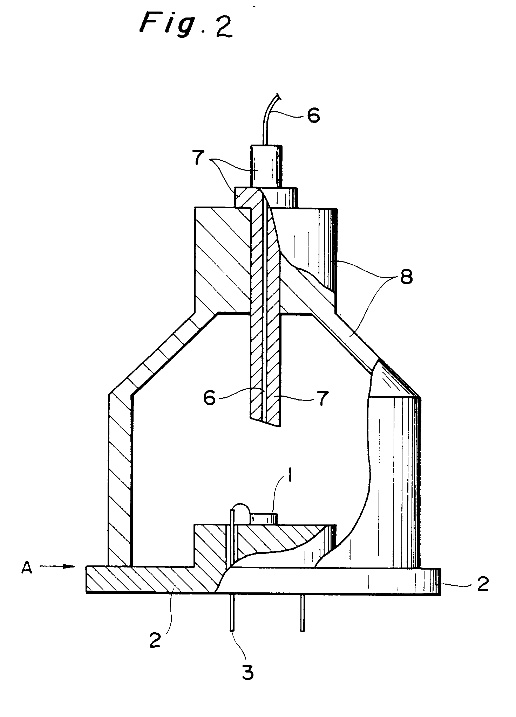

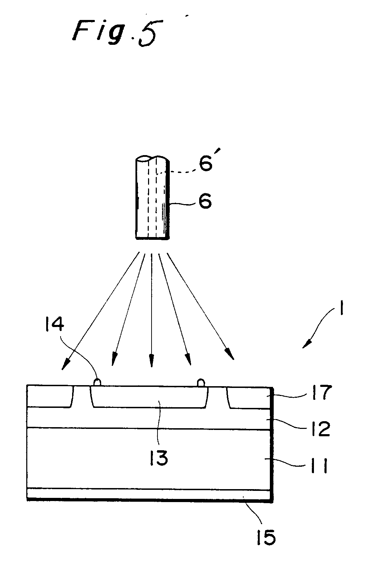

The semiconductor light detecting device according to the first embodiment of this invention is now described with reference to Figs. 2 and 5.

Fig. 2 is a side view of the semiconductor light detecting device according to the first embodiment with a major part broken.

Differences of the semiconductor light detecting device according to this embodiment from the conventional semiconductor light detecting devices are that as a photodiode chip 1, which is the light detecting device, a photodiode chip of the type (hereinafter called: charge capturing photodiode chip) that a photocurrent generated by the signal light radiated to a peripheral part of the p-n junction, which is the light detecting region, can be made unreactive. One example of such light detecting device is shown in Fig. 5. Furthermore, the optical fiber 6 is neighbored to the photodiode chip 1 to obtain a required sensitivity without the use of an optical lens system disposed therebetween.

As shown in Fig. 2, the photodiode chip 1 is mounted on a header 2, and a housing 8 is integrated with the header 2. An optical fiber 6 is inserted into the housing 8 through a ferrule 7. The light emitting end surface of the optical fiber 6 and the light detecting surface of the photodiode chip 1 are opposed to each other with no optical lens system therebetween.

As a photodiode chip 1 which is usable in the semiconductor light detecting device according to the first embodiment of the present invention, a charge capturing photodiode chip can be used, of the type that a photocurrent generated by the light radiated to a peripheral region of the p-n junction, which is the light detecting region, can be made unreactive. Fig. 5 shows the structure of one example of such photodiode chip 1.

A region 17 having the same polarity as the light detecting region 13 is formed by thermal diffusion of a metal element on an epitaxial layer 12 grown on a substrate, whereby the photocarriers generated in the region 17 do not flow to the region 13 but extinguish near the p-n junction between the epitaxial layer 12 and the region 17 or the p-n junction exposed on the end surfaces of the photodiode chip 1. European Patent Application EP-A-0473198 (which constitutes a document under Art.54(3)EPC) filed by the Applicant of this application shows more details.

Even in a case in which such improved photodiode chip 1 is used as the light detecting means, a generated photocurrent contains no component of slow response speed even in a condition in which a beam emitted from the end surface of the optical fiber 6 is divergent. Accordingly, it is unnecessary to use expensive lenses, and make subtle alignment of the optical fiber with the lenses. Inexpensive semiconductor light detecting devices can be very easily fabricated.

The inventors have fabricated as a first embodiment of the invention a semiconductor light detecting device of the structure of Fig. 2 for use in the optical communication of long wavelength band (1.1 - 1.6 µm).

The charge capturing photodiode chip 1 used as charge capturing photodiode chip comprises an InP substrate, a light detecting region 13 of 100 µm in diameter, i. e., a p-n junction, on an epitaxial layer 12 by Zn thermal diffusion formed in a charge capturing region 17 formed by the same method.

Needless to say, in this photodiode chip 1, the p-n junction is passivated by a SiN film, and the entire surface of the light detecting region 13 and the charge capturing region 17 are covered with an antireflection film. This photodiode chip 1 is bonded to the header 2 of covar by using AuSn and the photocurrent signal is led outside by an Au wire of 30 µm in diameter and a metal lead 3.

Then an optical fiber 6 having the signal light emitting end surface cut off at 8 degrees for the prevention of return light is fixed to a ferrule 7, and the ferrule 7 is secured to a stainless steel housing 8. A fixation position of the ferrule 7 is set at a geometrical optically computed value of a distance between the light detecting surface of the photodiode chip 1 and the leading end of the optical fiber 6 corresponding to a light detecting surface area of the photodiode chip 1.

Then, applying 1.3 µm-laser beams from the optical fiber 6 to the light detecting surface of the photodiode chip 1, and monitoring the photocurrents, the housing 8 is secured at the part A to the header 2 by a YAG laser welding machine. Because of the absence of a lens, actually in this operation, the core alignment and the welding can be completed in a short period of time (2 - 3 minutes), and 95% of thus-fabricated semiconductor light detecting devices exhibit a responsivity as high as 0.8 A/W.

In receiving 125 Mbps light signals by the digital communication by the use of the thus-fabricated semiconductor light detecting device, waveform distortions, and phenomena, such as jitters in which rises and falls of waveforms transiently deflect, are not observed at all. In a case where this semiconductor light detecting device is used as the light detecting part of a 40 channel analog image transmission device, the responsivity is sufficiently 0.8 A/W. Conventionally in spite of a high sensitivity thereof, because of phaseshifted signals due to a little leakage light, flicker appears in screens, but by the use of the semiconductor light detecting device according to this embodiment, no flicker appears. Since all the unnecessary light is absorbed by the antireflection-treated charge collecting region 17, neither reflected light nor scattered light, which results in noises in the optical communication, takes place.

Because optical fibers can be thus mounted on the semiconductor light detecting device in a short period of time which leads to lower costs, and no waveform distortions and noises occur in a number of applications, the semiconductor light detecting device according to the first embodiment of the invention accelerates at once wide applications of the optical communication which have been slow because of the expensiveness of the conventional semiconductor light detecting devices. In an alternative of the first embodiment of the invention, the semiconductor light detecting device may be applied to butterfly-type housings with a result of the same effects.

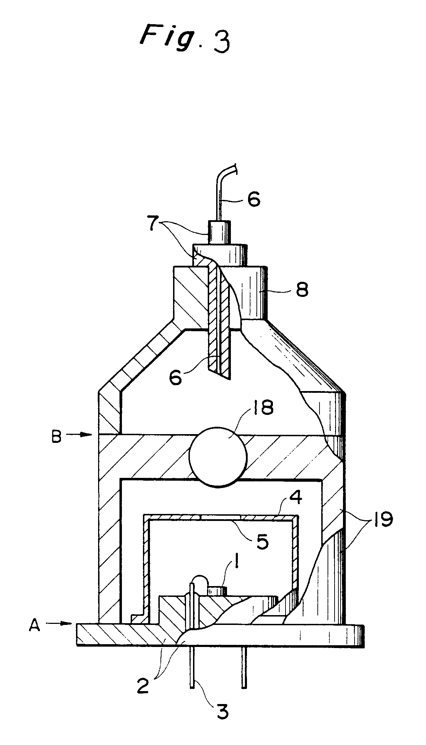

The semiconductor light detecting device according to a second embodiment of the invention will be explained with reference to Fig. 3.

Differences of the semiconductor light detecting device according to this embodiment from the conventional semiconductor light detecting devices are that as a photodiode chip 1, which is the light detecting device, a photodiode chip of the type (hereinafter called charge capturing type photodiode chip) that a photocurrent generated by the signal light radiated to a peripheral part of the p-n junction, which is the light detecting region, can be made unreactive, and the light emitted from the end surface of an optical fiber is applied to the light detecting surface of the photodiode chip 1 by an inexpensive spherical lens 18 as an optical lens system disposed therebetween.

As shown in Fig. 3, the photodiode chip 1 is mounted on a header 2, and the housing 8 is integrated with the header 2. An optical fiber 6 is inserted into the housing 8 through a ferrule 7, and the light emitting end surface of the optical fiber 6 and the light detecting surface of the photodiode chip 1 are opposed through the spherical optical lens 18.

As a photodiode chip 1 which is usable in the semiconductor light detecting device according to the second embodiment of this invention can be used a charge capturing photodiode chip in which a photocurrent generated by the light radiated to a peripheral region of the p-n junction, which is the light detecting region 13, is made unreactive. The structure of the photodiode chip 1 involved in this second embodiment is the same as that involved in the first embodiment.

The region 17 having the same polarity as the light detecting region 13 is formed on an epitaxial layer 12 grown on a substrate by thermal diffusion of a metal element, whereby photocarriers generated in the region 17 do not flow to the region 13 but are extinguished in a neighborhood of the p-n junction between the epitaxial layer 12 and the region 17, and the p-n junction exposed on the end surfaces of the photodiode chip 1. Japanese Patent Application No. 230206/1990 filed by the Applicant of this application shows the details of the structure and operation of the photodiode chip 1 involved in the second embodiment.

In using such improved photodiode chip 1, no low response speed component of a photocurrent is generated even in a state in which a light beam cannot be sufficiently condensed by the spherical lens 18. Resultantly, it is not necessary to use an expensive selfoc lens, and subtly align the core of the optical fiber 6. A very simple, inexpensive semiconductor light detecting device can be fabricated.

The inventors have fabricated as a second embodiment of the invention the semiconductor light detecting device of Fig. 3 to be used in the optical communication of a long wavelength band (1.1 - 1.6 µm).

The photodiode chip 1 is provided by a charge capturing photodiode chip comprising a 100 µm-light detecting region 13 of 100 µm diameter as the p-n junction formed on an epitaxial layer 12 of InGaAs by thermal diffusion of Zn on an InP substrate, and a charge capturing region 17 formed by the same method.

Needless to say, in the photodiode chip 1 the p-n junction is passivated by a SiN film, and the entire surface of the light detecting region 13 and the charge capturing region 17 are coated with an antireflection film. This photodiode chip 1 is bonded to a header 2 of covar by AuSn and the photocurrent signal is led outside by an Au wire of 30 µm in diameter and a metal lead 3.

Then a lens mount 19 for holding an inexpensive ball lens 18 is welded at the part A in Fig. 3 to a header 2 by YAG laser. A single mode fiber 6 having the signal light emitting end surface cut off at 8 degrees for the prevention of return light is fixed to a ferrule 7, and the ferrule 7 is secured to a stainless housing 8.

Then, while 1.3 µm laser beams are applied to the light detecting surface of the photodiode chip 1 from the end surface of the optical fiber, and the photocurrents are monitored, the housing 8 is secured at the part B in Fig. 3 to the lens mount 19. Actually in this operation, the spherical lens is used, and the condensation can be low, the core alignment and the welding can be done in a short period of time (5 - 10 minutes) , and 90 % of the thus-fabricated semiconductor light detecting devices exhibit a responsivity as high as 0.85 A/W.

In this second embodiment (Fig. 3) as in the first embodiment (Fig. 2), in receiving 125 Mbps light signals by the digital communication by the use of the thus-fabricated semiconductor light detecting device, waveform distortions, and phenomena, such as jitters in which rises and falls of waveforms transiently deflect, are not observed at all. In a case where this semiconductor light detecting device is used as the light detecting part of a 40 channel analog image transmission device, the responsivity is sufficiently 0.85 A/W. Conventionally in spite of a high sensitivity thereof, because of phase-shifted signals due to a little leakage light, flicker appears in screens, but by the use of the semiconductor light detecting device according to this embodiment, no flicker appears. Since all the unnecessary light is absorbed by the antireflection-treated charge capturing region 17, neither reflected light nor scattered light, which results in noises in the optical communication, takes place.

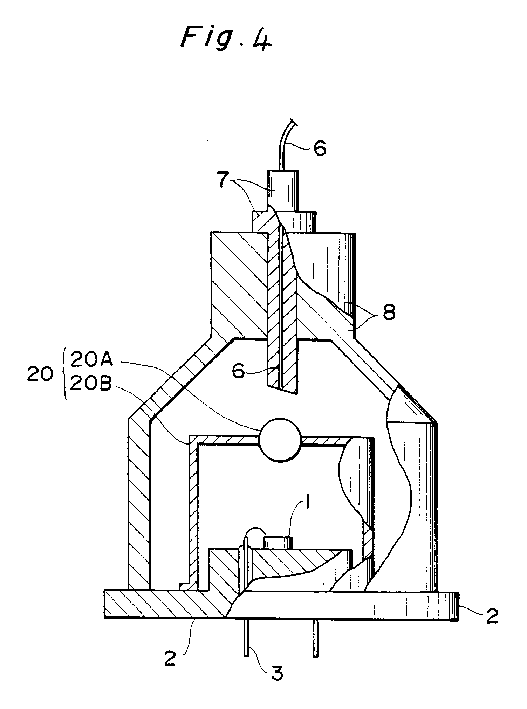

Fig. 4 is a broken side view of the semiconductor light detecting device according to an alternative of the second embodiment of this invention. The cap 4 and the lens 18 of the embodiment of Fig. 3 are replaced by a part 20 which is usually called lens cap combining the functions of the cap 4 and the lens 18 of Fig. 3 to decrease the number of the parts. Accordingly, an inexpensive semiconductor light detecting device is provided. Its fabrication method, the functions of the respective members, the effects of the invention are the same as in the above-described embodiment (Fig. 3).

The space airtightly closed by the header 2 and the cap 4 or 20 (Fig. 3 or 4) and accomodating the photodiode chip 1 is filled with an inert gas, e. g. nitrogen gas, in its dry state, so that even in low temperature conditions the inert gas does not bedew the surfaces of the semiconductor devices. Conventionally expensive optical systems have been used for the prevention of occurrences of leakage light, but these improved photodiode chips 1 allow inexpensive lenses to be used even with their imperfect condensation.

Because optical fibers can be thus mounted on the semiconductor light detecting device in a short period of time which leads to lower costs, and no waveform distortions and noises occur in a number of applications, the semiconductor light detecting device according to the second embodiment of this invention accelerates at once wide applications of the optical communication which have been slow because of the expensiveness of the conventional semiconductor light detecting devices. In an alternative of the second embodiment of this invention, the semiconductor light detecting device may be applied to butterfly-type housings with a result of the same effects.

The installation of the photodiode chip of a structure having a region for capturing unnecessary reactive carriers as the photodiode chip, which is the light detecting means, produces the following effects.

In the first embodiment, even in radiating the signal light from an optical fiber to the light detecting surface of the photodiode chip without an optical lens system being disposed therebetween, there is no occurrence of the signal waveform distortions (no slow response speed component of a photocurrent is generated). Furthermore an inexpensive semiconductor light detecting device without an expensive lens can be fabricated, and at the same time the semiconductor light detecting device has successfully solved the conventional problems that the reproduced (photoelectrically converted) signals of analog signal light have phase shifts and high distortion levels, and digital signals have distortions in the signal waveforms unsuitably for the high-speed communication.

In the second embodiment, even in applying the signal light emitted from the end surface of an optical fiber to the light detecting surface of the photodiode chip with an inexpensive spherical lens being disposed therebetween, no signal waveform distortion takes place (no slow response speed component of a photocurrent is generated). Thus an inexpensive semiconductor light detecting device using no expensive lens can be provided, and has successfully solved the problems that reproduced (photoelectrically converted) signals of analog signal light have phase shifts and high distortion levels, and signal waveforms of digital signals have distortions which is unsuitable for high-speed communication.

## Claims

1. A semiconductor light detecting device comprising:
an optical fibre (6) as an optical transmission path;
a housing (8) in which an end portion of the optical fibre (6) is inserted;
a header (2) secured to the housing (8) integrally therewith; and
a photodiode chip (1) mounted on the header (2) and accommodated in the housing (8), wherein the photodiode chip (1) has a light detecting endface which is disposed with respect to said optical fibre end portion inserted in the housing so as to be opposed to the light emitting endface of said fibre end portion whilst extending orthogonally to the longitudinal axis thereof;
**characterized in that**
the light emitting endface of said optical fibre end portion is inclined with respect to the normal to the longitudinal axis thereof, and therefore with respect to the light detecting endface of the photodiode chip (1); and
the photodiode chip (1) includes a layer (12) having a predetermined conductive type, a central region (13) formed in an outer surface of the layer and having a conductive type opposite to that of the layer (12), and a peripheral region (17) formed around the central region (13) in said layer outer surface and having the same conductive type as that of said central region (13), said peripheral region extending outwardly up to the outer surface of the chip (1) and said layer outer surface with said central and said peripheral region formed therein defining sald light detecting endface of the photodiode chip (1);
wherein said central region (13) forms with said layer (12) a central p-n junction functioning to output as a detected signal a photocurrent generated by signal light emitted from the light emitting endface of the optical fibre (6), and said peripheral region (17) forms with said layer (12) a peripheral p-n junction exposed on the lateral outer surfaces of the photodiode chip (1), whereby undesirable carriers generated at the chip periphery are captured and become extinct.

2. A semiconductor light detecting device according to claim 1, wherein
the layer (12) of a predetermined conductive type is an epitaxial layer (12) grown on a substrate (11) and the central region (13) and the peripheral region (17) are formed by thermal diffusion of a metal element in said epitaxial layer (12).

3. A semiconductor light detecting device according to claim 1 or 2, wherein
the light detecting endface of the photodiode chip (1) is opposed to the signal light emitting endface of the optical fibre (6) through an optical lens system (18; 2OA).

4. A semiconductor light detecting device according to claim 3, wherein
the optical fibre (6) and the photodiode chip (1) are incontiguously optically coupled with each other through the optical lens system (18; 2OA).

5. A semiconductor light detecting device according to any of claims 1 to 4, wherein
the photodiode chip (1) mounted on the header (2) is airtightly sealed with a cap (4), and the interior of the cap (4) is filled with an inactive fluid.

6. A semiconductor light detecting device according to claim 5, wherein
the cap (4) has a light transmitting window (5) for passing signal light emitted from the light emitting end face of the optical fibre (6) to the photodiode chip.

7. A semiconductor light detecting device according to any of claims 3 to 6, wherein
the optical lens system (18; 2OA) uses a spherical lens.

8. A semiconductor light detecting device according to claim 7, wherein
the spherical lens (18) is secured to a lens holder (19) together with the housing (8) to be integrated therewith.

9. A semiconductor light detecting device according to claim 5, wherein
the optical lens system (18, 20A) uses a spherical lens, and
the spherical lens (20A) is secured to the cap (20B) for airtightly sealing the photodiode chip (1) mounted on the header (2).

10. A semiconductor light detecting device according to claim 9, wherein
the spherical lens (20A) is secured in a aperture in the cap (20B) on the optical path between the optical fibre and the photodiode chip.

## Patentansprüche

1. Halbleiter-Lichtdetektorvorrichtung, umfassend:
eine optische Faser (6) als optischen Übertragungsweg;
ein Gehäuse (8), in das ein Endteil der optischen Faser (6) eingesetzt ist;
einen Träger (2), der am Gehäuse (8) einteilig mit diesem befestigt ist; und
einen Photodiodenchip (1), der auf dem Träger (2) montiert und im Gehäuse (8) untergebracht ist, wobei der Photodiodenchip (1) eine Licht erfassende Stirnfläche aufweist, die bezüglich des in das Gehäuse eingesetzten Endteils der optischen Faser so angeordnet ist, daß sie der Licht emittierenden Stirnfläche des Faserendteils gegenüberliegt, während sie sich senkrecht zu deren Längsachse erstreckt;
dadurch **gekennzeichnet**, daß
die Licht emittierende Stirnfläche des Endteils der optischen Faser bezüglich der Normalen zu deren Längsachse und daher bezüglich der Licht erfassenden Stirnfläche des Photodiodenchips (1) geneigt ist; und
der Photodiodenchip (1) eine Schicht (12) aufweist mit einem vorbestimmten Leitfähigkeitstyp, einem mittleren Bereich (13), der in einer Außenfläche der Schicht ausgebildet ist und einen Leitfähigkeitstyp entgegengesetzt zu jenem der Schicht (12) aufweist, und einem Randbereich (17), der um den mittleren Bereich (13) in der Schichtaußenfläche ausgebildet ist und denselben Leitfähigkeitstyp wie jenen des mittleren Bereichs (13) aufweist, wobei sich der Randbereich nach außen bis zur Außenfläche des Chips (1) erstreckt und die Schichtaußenfläche mit dem darin ausgebildeten mittleren Bereich und Randbereich die Licht erfassende Stirnfläche des Photodiodenchips (1) festlegt;
wobei der mittlere Bereich (13) mit der Schicht (12) einen zentralen p-n-Übergang bildet, welcher zur Ausgabe eines Photostroms als erfaßtes Signal wirkt, welcher durch aus der Licht emittierenden Stirnfläche der optischen Faser (6) emittiertes Signallicht erzeugt wird, und der Randbereich (17) mit der Schicht (12) einen peripheren p-n-Übergang bildet, der auf den seitlichen Außenflächen des Photodiodenchips (1) freiliegt, wobei unerwünschte Ladungsträger, die am Chiprand erzeugt werden, eingefangen und vernichtet werden.

2. Halbleiter-Lichtdetektorvorrichtung nach Anspruch 1, wobei
die Schicht (12) eines vorbestimmten Leitfähigkeitstyps eine Epitaxialschicht (12) ist, die auf ein Substrat (11) aufgewachsen ist, und der mittlere Bereich (13) und der Randbereich (17) durch Thermodiffusion eines Metallelements in der Epitaxialschicht (12) ausgebildet werden.

3. Halbleiter-Lichtdetektorvorrichtung nach Anspruch 1 oder 2, wobei
die Licht erfassende Stirnfläche des Photodiodenchips (1) der Signallicht emittierenden Stirnfläche der optischen Faser (6) durch ein optisches Linsensystem (18; 20A) gegenüberliegt.

4. Halbleiter-Lichtdetektorvorrichtung nach Anspruch 3, wobei
die optische Faser (6) und der Photodiodenchip (1) durch das optische Linsensystem (18; 20A) beabstandet optisch miteinander gekoppelt sind.

5. Halbleiter-Lichtdetektorvorrichtung nach einem der Ansprüche 1 bis 4, wobei
der auf dem Träger (2) montierte Photodiodenchip (1) luftdicht mit einer Kappe (4) verschlossen ist und das Innere der Kappe (4) mit einem inaktiven Fluid gefüllt ist.

6. Halbleiter-Lichtdetektorvorrichtung nach Anspruch 5, wobei
die Kappe (4) ein lichtdurchlässiges Fenster (5) zum Durchlassen von Signallicht, das von der Licht emittierenden Stirnfläche der optischen Faser (6) emittiert wird, zum Photodiodenchip aufweist.

7. Halbleiter-Lichtdetektorvorrichtung nach einem der Ansprüche 3 bis 6, wobei
das optische Linsensystem (18; 20A) eine sphärische Linse verwendet.

8. Halbleiter-Lichtdetektorvorrichtung nach Anspruch 7, wobei
die sphärische Linse (18) an einem Linsenhalter (19) zusammen mit dem Gehäuse (8) zur Eingliederung in dieses befestigt ist.

9. Halbleiter-Lichtdetektorvorrichtung nach Anspruch 5, wobei
das optische Linsensystem (18, 20A) eine sphärische Linse verwendet und
die sphärische Linse (20A) zum luftdichten Einschließen des auf dem Träger (2) montierten Photodiodenchips (1) an der Kappe (20B) befestigt ist.

10. Halbleiter-Lichtdetektorvorrichtung nach Anspruch 9, wobei
die sphärische Linse (20A) in einer Öffnung in der Kappe (20B) auf dem Strahlengang zwischen der optischen Faser und dem Photodiodenchip befestigt ist.

## Revendications

1. Dispositif de détection de lumière à semiconducteur comportant :
une fibre optique (6) en tant que trajet de transmission optique ;
un boîtier (8) dans lequel est introduite une partie terminale de la fibre optique (6) ;
une tête (2) fixée au boîtier (8) et faisant corps avec lui ; et
une puce photodiode (1) montée sur la tête (2) et logée dans le boîtier (8), laquelle puce photodiode (1) possède une surface terminale de détection de lumière qui est disposée par rapport à ladite partie terminale de fibre optique introduite dans le boîtier de manière à être en vis-à-vis de la face terminale émettrice de lumière de ladite partie terminale de la fibre tout en s'étendant orthogonalement à l'axe longitudinal de celle-ci ;
caractérisé en ce que
la face terminale émettrice de lumière de ladite partie terminale de la fibre optique est inclinée par rapport à la normale sur l'axe longitudinal de celle-ci, et par conséquent par rapport à la face terminale de détection de lumière de la puce photodiode (1) ; et
la puce photodiode (1) comprend une couche (12) ayant un type de conductivité prédéterminé, une région centrale (13) formée dans une surface extérieure de la couche et ayant un type de conductivité opposé à celui de la couche (12), et une région périphérique (17) formée autour de la région centrale (13) dans ladite surface extérieure de la couche et ayant le même type de conductivité que celui de ladite région centrale (13), ladite région périphérique s'étendant vers l'extérieur jusqu'à la surface extérieure de la puce (1) et ladite surface extérieure de la couche avec ladite région centrale et ladite région périphérique formées dans celle-ci délimitant ladite face terminale de détection de lumière de la puce photodiode (1) ;
dans lequel ladite région centrale (13) forme avec ladite couche (12) une jonction p-n centrale fonctionnant pour délivrer en tant que signal détecté un photocourant généré par une lumière de signal émise depuis la face terminale émettrice de lumière de la fibre optique (6), et ladite région périphérique (17) forme avec ladite couche (12) une jonction p-n périphérique exposée sur les surfaces extérieures latérales de la puce photodiode (1), de manière que des porteurs indésirables générés à la périphérie de la puce soient capturés et soient annulés.

2. Dispositif de détection de lumière à semiconducteur selon la revendication 1, dans lequel la couche (12) d'un type de conductivité prédéterminé est une couche épitaxiale (12) que l'on a fait croître sur un substrat (11) et la région centrale (13) et la région périphérique (17) sont formées par diffusion thermique d'un élément métal dans ladite couche épitaxiale (12).

3. Dispositif de détection de lumière à semiconducteur selon la revendication 1 ou 2, dans lequel la face terminale de détection de lumière de la puce photodiode (1) se trouve en vis-à-vis de la face terminale émettrice de lumière de signal de la fibre optique (6) avec interposition d'un système de lentille optique (18 ; 20A).

4. Dispositif de détection de lumière à semiconducteur selon la revendication 3, dans lequel la fibre optique (6) et la puce photodiode (1) sont couplées optiquement entre elles de façon non adjacente par l'intermédiaire du système de lentille optique (18 ; 20A).

5. Dispositif de détection de lumière à semiconducteur selon l'une quelconque des revendications 1 à 4, dans lequel la puce photodiode (1) montée sur la tête (2) est scellée de façon hermétique à l'air à l'aide d'un bouchon (4), et l'intérieur du bouchon (4) est rempli d'un fluide inerte.

6. Dispositif de détection de lumière à semiconducteur selon la revendication 5, dans lequel le bouchon (4) possède une fenêtre de transmission de lumière (5) afin de transmettre la lumière de signal émise par la face terminale émettrice de lumière de la fibre optique (6) à la puce photodiode (7).

7. Dispositif de détection de lumière à semiconducteur selon l'une quelconque des revendications 3 à 6, dans lequel le système de lentille optique (18 ; 20A) utilise une lentille sphérique.

8. Dispositif de détection de lumière à semiconducteur selon la revendication 7, dans lequel la lentille sphérique (18) est fixée à un support de lentille (19) conjointement avec le boîtier (8) pour faire corps avec celui-ci.

9. Dispositif de détection de lumière à semiconducteur selon la revendication 5, dans lequel le système de lentille optique (18 ; 20A) utilise une lentille sphérique, et
la lentille sphérique (20A) est fixée au bouchon (20B) afin de sceller de façon hermétique à l'air la puce photodiode (1) montée sur la tête (2).

10. Dispositif de détection de lumière à semiconducteur selon la revendication 9, dans lequel la lentille sphérique (20A) est fixée dans une ouverture du bouchon (20B) sur le trajet optique entre la fibre optique et la puce photodiode.
